# FASCICULE DE BREVET EUROPEEN

(11) **EP 1 269 702 B1**
(45) Date de publication et mention de la délivrance du brevet: **23.01.2013**
(21) Numéro de dépôt: 01917192.5
(22) Date de dépôt: 20.03.2001
(51) Int. Cl.: H04L 25/06, G06K 7/10, H03K 5/08, H03D 1/10, G06K 7/00, G06K 19/07

(54) **DEMODULATEUR D'UN SIGNAL ALTERNATIF MODULE EN AMPLITUDE**
DEMODULATOR FÜR EIN AMPLITUDENMODULIERTES ALTERNIERENDES SIGNAL
DEMODULATOR OF AN AMPLITUDE-MODULATED ALTERNATING SIGNAL

(30) Priorité: 21.03.2000 FR 0003606
(43) Date de publication de la demande: 02.01.2003
(73) Titulaire: Gemalto SA, 92190 Meudon (FR); STMicroelectronics S.A., 92120 Montrouge (FR)
(72) Inventeur: DELL'OVA, Francis, F-13710 Fuveau (FR); RIZZO, Pierre, F-13400 Aubagne (FR)
(74) Mandataire: Bentz, Jean-Paul
(86) Numéro de dépôt international: PCT/FR2001/000832
(87) Numéro de publication internationale: WO 2001/071997

(56) Documents cités:
- EP-A- 0 338 517
- WO-A-99/42948
- US-A- 3 638 183
- US-A- 4 362 996
- US-A- 4 672 238
- US-A- 4 943 736
- US-A- 6 031 419

## Description

La présente invention concerne un démodulateur d'un signal alternatif modulé en amplitude basé sur le principe de la détection de crête et de creux. L'invention concerne également un dispositif sans contact comportant un tel démodulateur.

Le démodulateur selon l'invention trouve une application particulièrement avantageuse dans le domaine de la communication par Radio Fréquence (RF) de longue portée. Des dispositifs portables à communication sans contact tels que des cartes à puce sans contact, des étiquettes électroniques ou des badges fonctionnent sur la base d'une communication par champ magnétique avec un organe interrogateur de lecture et/ou écriture appelé communément lecteur. Ces dispositifs sans contact comportent généralement un microcircuit connecté à un circuit résonnant de type L,C parallèle. La self est une antenne extérieure alors que la capacité est intégrée au microcircuit. L'ensemble constitue ce qui est communément appelé « circuit d'accord ».

A titre d'exemple, dans certaines applications carte à puce sans contact, le lecteur émet un signal hertzien ayant une fréquence porteuse de 13,56 MHz.

Ce signal émis permet d'une part d'alimenter la carte sans contact qui se procure ainsi l'énergie nécessaire à son fonctionnement par induction, et d'autre part, d'établir une communication entre la carte et le lecteur selon un protocole établi. Ainsi, lorsque la carte sans contact pénètre dans le champ d'émission du lecteur, elle communique avec ce dernier par une opération de modulation qui consiste à modifier au moins un paramètre de la porteuse.

Le dispositif sans contact reçoit de la part du lecteur un signal modulé en amplitude par le biais du circuit d'accord. L'interprétation du message du lecteur par le dispositif sans contact se fait par une opération de démodulation qui consiste à extraire le signal modulé de la porteuse. La fréquence du signal modulé est largement inférieure à celle de la porteuse, en général une dizaine de kHz.

La qualité et la fiabilité de la communication RF sont directement liées, entre autre, à la distance entre le lecteur et le dispositif sans contact. La distance, ou la portée, de la communication RF entre le lecteur et le dispositif sans contact dépend de plusieurs paramètres dont la fréquence d'accord entre le circuit résonnant du dispositif sans contact et la fréquence d'émission du signal du lecteur, ainsi que de la qualité de la démodulation du signal modulé.

La qualité de la démodulation du signal modulé dépend directement de la distance entre le dispositif sans contact et le lecteur ainsi que de la vitesse de déplacement du dispositif dans le champ d'émission du lecteur. Plus la portée est grande et le dispositif furtif, plus la démodulation sera entachée d'erreurs.

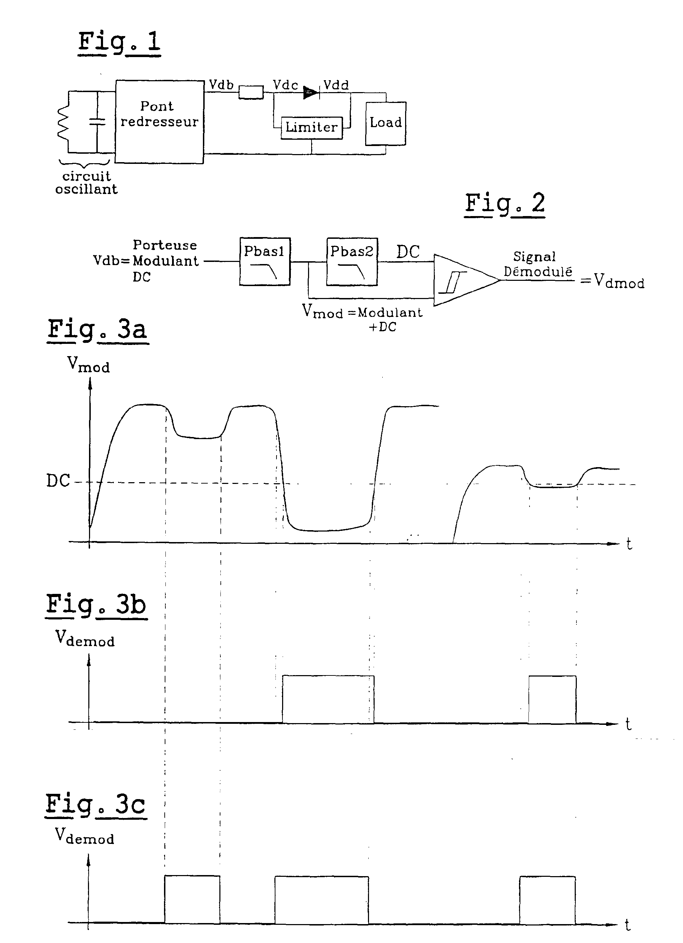

Un schéma bloc des étages d'entrée du dispositif sans contact est illustré sur la figure 1. Un circuit résonnant, centré sur la fréquence de la porteuse, reçoit un signal hertzien modulé. Un pont redresseur génère une tension continue afin d'alimenter le dispositif sans contact. La tension à la sortie du pont redresseur Vdb représente la tension directe après redressement et contient à la fois l'énergie nécessaire à l'auto-alimentation du dispositif sans contact et l'information du signal modulé.

Pour des applications utilisant une modulation d'amplitude de 100%, une diode isole le circuit résonnant de la charge et élimine ainsi toute possibilité de retour de courant vers le circuit résonnant. Un limiteur permet de maintenir la tension d'alimentation Vdd inférieure à un seuil, de 4V par exemple. Une résistance est avantageusement placée entre Vdb et la diode afin d'isoler le signal modulé sur Vdb. Ainsi, la démodulation du signal modulé provenant du lecteur se fait directement à partir du signal Vdb en sortie du pont redresseur du dispositif sans contact.

Un dispositif classique de démodulation en amplitude est illustré schématiquement sur la figure 2.

Le signal Vdb est tout d'abord traité par un filtre passe bas, de type RC, afin d'éliminer les composantes de la porteuse pour en retirer d'une part l'enveloppe du signal modulé, que l'on appelle communément le signal modulant de référence Vmod, et d'autre part sa composante continue DC. Une fréquence de coupure de quelques dizaines de kHz peut être choisie pour ce premier filtre. Le niveau continu DC est ensuite extrait par un nouveau filtre passe bas dont la fréquence de coupure est inférieure à la fréquence du signal modulant Vmod, quelques kHz par exemple. Le signal de démodulation Vdemod peut alors être obtenu par comparaison entre le signal modulant de référence Vmod et son niveau continu DC.

Un tel dispositif de démodulation présente des limitations dues à sa structure même. En effet, le niveau continu DC est largement variable en fonction du positionnement de la carte dans le champ du lecteur, et de sa vitesse de déplacement. Cet état de fait rend la génération d'un niveau de comparaison fiable difficile à obtenir de façon permanente. Ce problème est même accentué pour des applications où une grande portée, 50cm à 1m environ, est requise.

Le document de brevet US-A-6 031 419 décrit un démodulateur pour carte à puce sans contact rendu avantageusement insensible au niveau du signal reçu en faisant varier le seuil du niveau de comparaison en fonction du niveau moyen du signal reçu.

Les graphes des figures 3a à 3c illustrent toutefois d'autres limites des dispositifs classiques de démodulation.

Le signal modulant de référence Vmod est reporté sur la figure 3a avec son niveau continu DC. Le signal de démodulation Vdemod est reporté sur la figure 3b. On constate que certaines modulations peuvent ne pas être détectées et que les modulations identifiées par le dispositif ne le sont pas parfaitement, c'est à dire que le début et la fin de la modulation ne sont pas précisément repérés.

La figure 3c illustre à cet effet l'objectif de la présente invention qui consiste à réaliser, pour un dispositif sans contact, un démodulateur capable de repérer avec précision le début et la fin de tous les signaux modulés émis par le lecteur.

La présente invention a pour but de résoudre les inconvénients de l'art antérieur, et de proposer un démodulateur actif basé sur le principe de « détection de crête et de creux » selon la revendication 1.

Le démodulateur selon l'invention est dit « actif », c'est à dire qu'il est apte à générer, en suivant le signal modulé de façon dynamique, un seuil bas et un seuil haut qui permettent de repérer précisément le début et la fin de la modulation.

Un tel démodulateur est principalement constitué de deux démodulateurs indépendants respectivement optimisés pour détecter le début et la fin du signal modulé.

Le démodulateur selon l'invention permet d'encadrer très précisément le début et la fin de la modulation. Il est ainsi possible de s'affranchir des contraintes liées aux grandes variations de niveaux continus des signaux modulés.

Ainsi, le démodulateur selon l'invention peut être utilisé dans le cadre d'applications pour lesquelles une grande portée de communication et une vitesse de déplacement élevée sont requises entre le dispositif sans contact et le lecteur.

D'autres particularités et avantages de la présente invention apparaîtront au cours de la description qui suit donnée à titre d'exemple illustratif et non limitatif en référence aux figures dans lesquelles :
- la figure 1, déjà décrite, est un schéma bloc des étages d'entrée du dispositif sans contact ;
- la figure 2, déjà décrite, est un schéma de principe classique de la démodulation d'un signal ;
- les figures 3a à 3c, déjà décrites, sont des graphes illustrant respectivement le signal modulé et son niveau continu, le signal démodulé avec un dispositif classique et le signal démodulé avec le démodulateur selon l'invention ;

- la figure 4 est un schéma de principe du démodulateur selon l'invention ;
- la figure 5 est un schéma de principe d'une cellule de base pour la « détection de crête» ;
- la figure 6 est un graphe illustrant le signal modulant de référence du signal modulé ;
- la figure 7 est un schéma bloc de l'implémentation du démodulateur selon l'invention dans un dispositif sans contact ;
- la figure 8 illustre schématiquement la détection du début de la modulation par le démodulateur selon l'invention ;
- la figure 9 illustre schématiquement la détection de la fin de la modulation par le démodulateur selon l'invention ;
- la figure 10 illustre graphiquement le signal démodulé par le démodulateur selon l'invention ;
- la figure 11 est un schéma de l'unité logique du démodulateur selon l'invention ;
- les figures 12a à 12c sont des graphes illustrant respectivement le signal modulé, le signal modulant de référence et le signal démodulé par le démodulateur selon l'invention.

Dans la description qui suit, on se réfère à une carte sans contact recevant de la part d'un lecteur un signal modulé en amplitude dont la fréquence de porteuse est 13.56 MHz et l'index de modulation de 10%. L'application requière une portée de la communication RF pouvant atteindre 1m pour une vitesse de déplacement de la carte dans le champ du lecteur pouvant atteindre 3m/s.

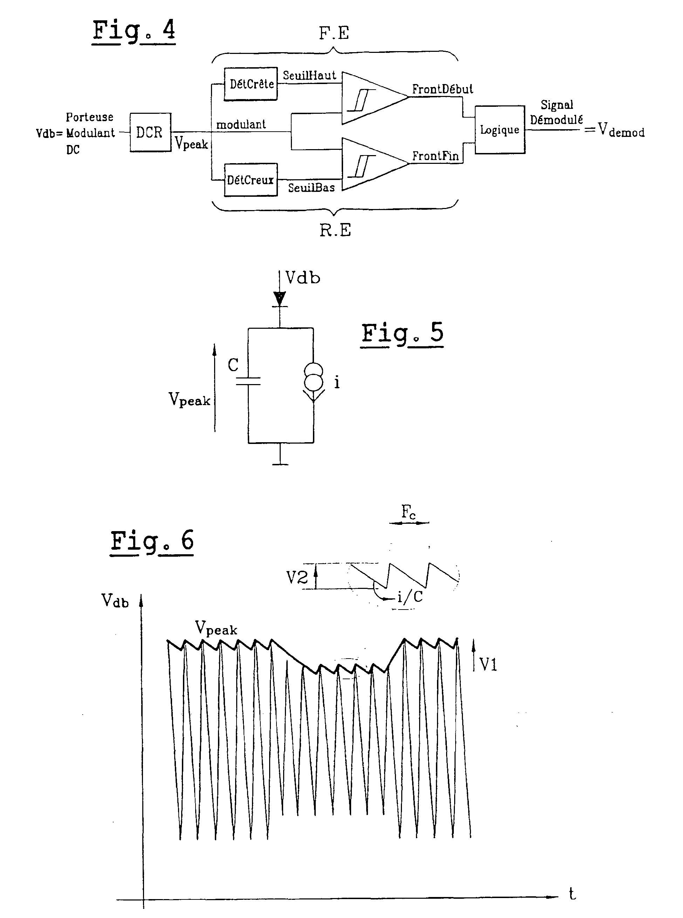

En se référant à la figure 4, qui est un schéma de principe du démodulateur selon l'invention, le signal modulé Vdb est tout d'abord traité par une cellule de « détection de crête » DCR qui extrait le signal modulant de référence Vpeak.

Deux démodulateurs indépendants FE et RE, placés en parallèle, vont alors détecter respectivement le début et la fin de la modulation, ces résultats intermédiaires sont ensuite traités numériquement par une logique pour produire le signal démodulé.

Le premier démodulateur sera dénommé par la suite « Falling Edge » FE car il détecte le seuil haut du signal modulant de référence Vpeak et repère le début de la modulation lors d'une chute de tension sur Vpeak (chute produite par la modulation 10% de l'exemple considéré).

Le second démodulateur sera dénommé par la suite « Rising Edge » RE car il détecte un creux dans le signal modulant de référence Vpeak (creux correspondant à la modulation 10%) pour générer un seuil bas propre à cette modulation et repèrer la fin de la modulation lors de la remonté de la tension Vpeak.

On obtient ainsi un démodulateur dynamique qui suit l'évolution du signal modulé pour repérer en temps réel le début et la fin de la modulation.

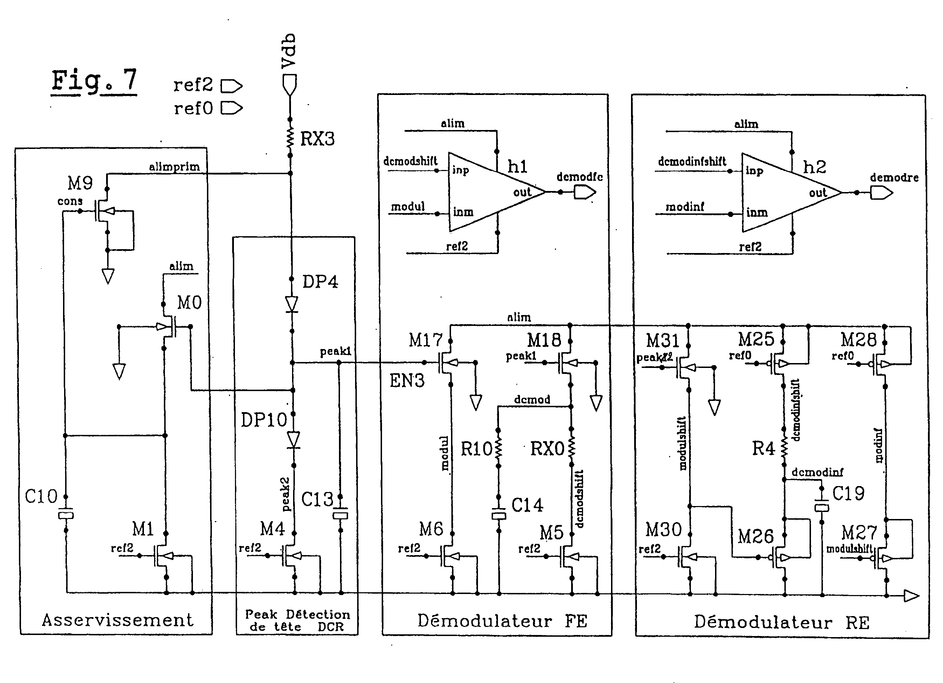

Le démodulateur selon l'invention comporte plusieurs blocs électroniques pour sa mise en oeuvre. Ces différents blocs sont illustrés sur la figure 7 par des schémas électroniques. Cette figure ne représente qu'un exemple d'implémentation dans une carte sans contact ou un badge électronique et ne doit en aucun cas être restrictive.

La première étape de mise en oeuvre consiste à extraire un signal modulant (une enveloppe) de référence du signal modulé Vdb afin d'en éliminer la porteuse.

A cet effet, on réalise une première détection de crête DCR à partir d'une cellule de base schématisée sur la figure 5. Une telle cellule se compose essentiellement d'une diode, d'une capacité et d'une source de courant continu, et va permettre d'extraire le signal modulant de référence Vpeak du signal modulé Vdb.

Lorsque l'on considère un signal modulé Vdb double alternance, la capacité C ne peut être chargée que pendant l'alternance positive de Vdb, c'est à dire quand Vdb-Vpeak>Vd, avec Vd la tension de seuil de la diode. Dès que cette relation n'est plus vérifiée, la diode de la cellule de base se bloque et la capacité C a un effet mémoire, c'est à dire qu'à l'instant du blocage de la diode, on a très précisément Vpeak=Vdb(crête)-Vd. La capacité C est ensuite déchargée à courant constant et Vpeak diminue selon la relation dVpeak/dt=-i/C.

Il faut par conséquent choisir une constante de temps adaptée, de quelque dizaine de kHz par exemple, pour récupérer le signal modulé sans atténuation tout en limitant la résultante due à la porteuse. En effet, la fréquence du signal modulé est lente par rapport à celle de la porteuse.

La figure 6 est un graphe illustrant le signal modulant de référence Vpeak issu du signal modulé Vdb par la cellule de base de la figure 5.

Si V1 est la profondeur de la modulation (10% par exemple) et V2 la résultante de la porteuse sur le signal extrait Vpeak, on peut considérer que V2 est un niveau de bruit sur Vpeak. Av^ec une fréquence de porteuse de Fc, on peut estimer V2(max)=i/(C*Fc), ce qui correspond à la décharge de la capacité sur une période entière de la porteuse.

Dans l'exemple d'implémentation de la figure 7, le signal modulant de référence Vpeak1 est directement extrait à partir du signal modulé Vdb provenant de l'antenne. On définit les paramètres du miroir de courant M4 et de la capacité C13, pour obtenir une pente de décharge de Vpeak1 de 600kV/s.

Suites à différentes simulations réalisées avec plusieurs cartes sans contact, on a pu établir une modulation maximale de 500mV en 1µs, soit une pente de 500kV/s, ce qui est inférieur à la pente de décharge (600kV/s) de la cellule de détection de crête DCR du démodulateur selon l'invention.

La résultante de la porteuse V2 peut être estimée à 44mV pour une fréquence de porteuse de 13.56MHz. Le niveau de bruit est donc acceptable pour une profondeur de modulation de 500mV.

Une image Vpeak2 du signal modulant de référence Vpeak1 est réalisée grâce à un simple décalage au moyen d'une diode. Ce sont ces deux signaux Vpeak1 et Vpeak2 qui seront ensuite utilisés respectivement par les démodulateurs FE et RE dont les résultats seront traités par une unité logique non illustrée sur la figure 7.

Il est à noter que le démodulateur selon l'invention est en outre pourvu d'un système d'asservissement qui permet de fixer le signal modulant de référence Vpeak1 au plus haut de la dynamique admissible pour le démodulateur, quelle que soit son alimentation qui peut être comprise entre 2V et 5V par exemple. Un transistor haute tension M9 tire un courant variable en fonction du niveau du signal modulé Vdb à travers une résistance RX3. On obtient ainsi un décalage variable entre Vdb et l'alimentation.

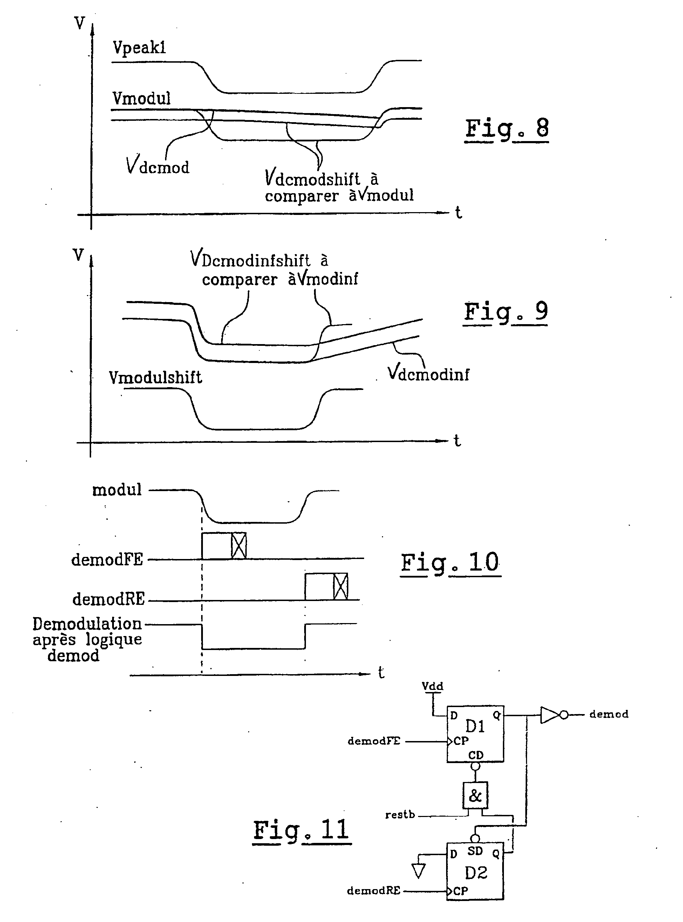

On se réfère maintenant aux figures 7 et 8 illustrant le fonctionnement du démodulateur FE qui repère le début de la modulation.

Ce démodulateur FE est également basé sur le principe de la détection de crête, mais la diode est remplacée par un transistor Nmos monté en suiveur. Comme illustré sur la figure 7, les transistors M17 et M18 sont des transistors montés en suiveur et polarisés par les miroirs de courant M5 et M6.

Le transistor M17 opère une recopie du signal modulant de référence Vpeak1 en Vmodul avec un décalage de Vt correspondant à la tension de seuil du transistor M17, de 0.7V par exemple.

Le transistor M18 agit comme la diode de la cellule de base de la détection de crête DCR pour créer un seuil haut Vdcmod sur le signal Vmodul. Vdcmod représente la tension aux bornes de la capacité C14.

En absence de modulation, M18 charge la capacité C14 et on a alors Vdcmod=Vmodul (Vdcmod est sur la crête du signal modulé). Lorsque la modulation d'amplitude commence, la tension Vpeak1 chute et on a alors Vpeak1-Vt < Vmodul. Le transistor M18 se bloque et la capacité C14 est déchargée à courant constant par le miroir de courant M5 qui polarise le transistor M18. Vdcmod représente alors la décharge de la capacité C14 à courant constant. La pente de décharge de Vdcmod est fixée à 75kV/s.

Cette décharge est lente par rapport à la modulation, mais doit cependant être plus rapide qu'une baisse possible de l'alimentation lorsque la carte s'éloigne du lecteur. Si on considère une carte d'une portée de 50cm se déplaçant à 3m/s par rapport au lecteur, et si on considère en première approximation que la tension interne d'alimentation est proportionnelle à la distance de communication entre l'étiquette et le lecteur, on peut varier de 2V à 4V sur 50cm en 1/6s, ce qui nous donne une pente minimum de décharge de 12V/s à comparer avec les-75kV/s.

Vdcmod repère la crête du signal Vmodul. Pour créer un seuil de comparaison, on recopie Vdcmod en Vdcmodshift en utilisant une chute de potentiel à travers une résistance RX0 traversée par le courant de polarisation. On peut ainsi obtenir un décalage d'environ 110mV avant hystérésis entre Vdcmod et Vdcmodshift.

Le début de la modulation est déterminé par le croisement de Vmodul avec Vdcmodshift. Ces deux signaux sont traités par un comparateur présentant un hystérésis de 50mV suffisant pour éliminer de possibles transitions multiples dues à la résultante de la porteuse. Le seuil de déclenchement de la détection du début de la modulation est donc de 160mV environ, ce qui est relativement précis si on a une profondeur de modulation de 500mV et ne peut être confondu avec une résultante de la porteuse estimée à 44mV.

De même, la détection de la fin de la modulation par le démodulateur RE est illustrée dans son principe sur la figure 9.

Alors que le démodulateur FE traque la crête du signal modulé afin de générer un seuil inférieur à celle-ci et repérer le début de la modulation, le démodulateur RE traque les creux du signal modulé (pendant lesquels il y a modulation) afin de générer un seuil supérieur à ceux-ci et repérer la fin de la modulation.

A cet effet, il est nécessaire de parvenir à décharger une capacité rapidement afin de mémoriser le niveau du creux, puis à recharger cette capacité à courant constant pour créer une pente de recharge qui puisse générer un seuil de comparaison.

On utilise à cette fin des transistors Nmos M31 et Pmos M26 et M27 montés en suiveur et polarisés par les miroirs de courant M30, M25 et M28. Le transistor M31 recopie Vpeak2 en Vmodulshift, et le transistor M27 recopie Vmodulshift en Vmodinf avec un décalage de Vtp égale à 1V environ.

L'objectif de ce double recopiage est de recentrer le signal Vmodinf, qui va être utilisé pour les comparaisons, dans la dynamique du système. En effet, l'asservissement maintient Vpeak1 environ au niveau de l'alimentation. Vmodulshift est la recopie décalée de Vpeak2, c'est à dire l'image de Vpeak1 décalé d'un seuil de diode plus d'un seuil de transistor Nmos, soit un décalage de -1.4V. Or, sachant que la détection dans le démodulateur RE se fait avec des transistors Pmos, il est nécessaire de remonter les niveaux des signaux, c'est pourquoi on travaille avec Vmodinf qui correspond environ à Vpeak1-0.4V et qui restera donc dans la dynamique d'entrée du comparateur du démodulateur RE.

Le seuil bas au creux du signal Vmodinf sera représenté par la tension aux bornes de la capacité C19, Vdcmodinf.

En absence de modulation, la capacité C19 est chargée. Lorsque la modulation intervient, Vmodulshift chute et devient inférieur à Vdcmodinf-Vtp. Le transistor M26 devient passant et décharge C19 rapidement tant que Vdcmodinf ne retrouve pas le niveau de Vmodulshift+Vtp, soit Vdcmodinf=Vmodinf. On a bien Vdcmodinf dans le creux de l'image du signal modulé Vmodinf.

Lorsque la modulation se termine, Vmodulshift remonte et bloque le transistor M26 qui ne tire plus de courant sur la capacité C19. Celle-ci peut alors être rechargée à courant constant par le miroir de courant M25. La constante de temps du démodulateur RE est choisie identique à celle du démodulateur FE, soit 75kV/s dans l'exemple considéré.

Le signal Vdcmodinf repère le creux du signal Vmodinf. Comme précédemment, pour créer un seuil de comparaison, on recopie Vdcmodinf en Vdcmodinfshift par une chute de potentiel à travers une résistance RX4 traversée par le courant de polarisation. On peut ainsi obtenir un décalage d'environ 75mV avant hystérésis entre Vdcmodinf et Vdcmodinfshift.

La fin de la modulation est déterminée par le croisement de Vmodinf avec Vdcmodinfshift. Ces deux signaux sont traités par le même type de comparateur que celui utilisé pour le démodulateur FE, présentant un hystérésis de 50mV. Le seuil de déclenchement de la détection de la fin de la modulation est donc de 125mV environ.

Le signal démodulé par le démodulateur selon l'invention correspond au traitement logique des sorties des deux comparateurs des deux démodulateurs FE et RE, comme cela est représenté sur la figure 11.

La figure 10 illustre graphiquement les signaux de sortie des comparateurs. Une image du signal modulé est donnée par le graphe "modul", la sortie du comparateur du démodulateur FE est représentée par le graphe "demodFE" qui repère précisément le début de la modulation, et la sortie du comparateur du démodulateur RE est représentée par le graphe "demodRE" qui repère précisément la fin de la modulation. Le signal démodulé est représenté sur le dernier graphe.

La logique du démodulateur selon l'invention est prévue pour détecter le premier croisement entre le signal modulé et les seuils de comparaison, le second croisement ne représentant aucune information intéressante dans l'application considérée.

Comme illustré sur la figure 11, le premier croisement détecté par le comparateur FE actionne une première bascule D1 qui annonce ainsi le début de la modulation, et le premier croisement détecté par le comparateur RE actionne une seconde bascule D2 qui annonce ainsi la fin de la modulation.

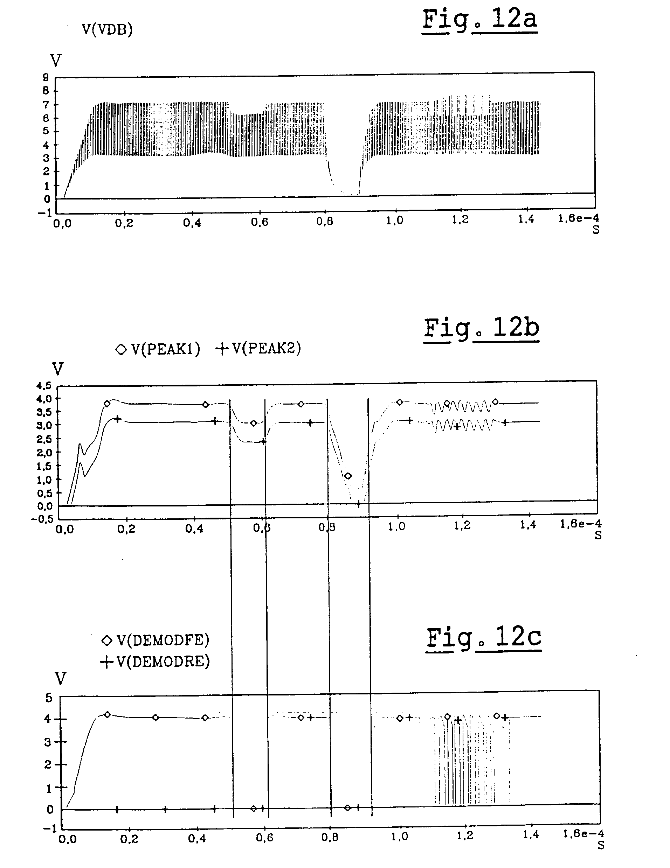

Les figures 12a à 12c sont des graphes illustrant des simulations de démodulation d'un signal Vdb avec un démodulateur selon l'invention. Le graphe 12c illustre bien la finesse de précision de la démodulation.

## Revendications

1. Démodulateur d'un signal modulé en amplitude (Vdb), comprenant
une première cellule de détection de crête (DCR) apte à extraire le signal modulant de référence (Vpeak1) du signal modulé (Vdb), **caractérisé en ce qu'**il comprend :
- un premier démodulateur (FE) apte à opérer une première recopie décalée (Vmodul) du signal modulant de référence (Vpeak1) dite premier signal de référence décalé (Vmodul), et comportant une deuxième cellule de détection de crête (Vdcmod) du premier signal de référence décalé (Vmodul) de manière à générer un seuil haut de comparaison (Vdcmodshift), un premier comparateur étant apte à détecter le croisement entre le seuil haut (Vdcmodshift) et le premier signal de référence décalé (Vmodul) pour repérer le début de la modulation.
- un second démodulateur (RE) apte à opérer une deuxième recopie décalée (Vmodinf) du signal modulant de référence (Vpeak1), dite deuxième signal de référence décalé (Vmodinf), et comportant une cellule de détection de creux (Vdcmodinf) un deuxième signal de référence décalé (Vmodinf) de manière à générer un seuil bas de comparaison (Vdcmodinfshift), le seuil bas étant inférieur au seuil haut de comparaison, un deuxième comparateur étant apte à détecter le croisement entre le seuil bas (Vdcmodinfshift) et le deuxième signal de référence décalé (Vmodinf) pour repérer la fin de la modulation ; et
- une unité de traitement logique apte à fournir le signal démodulé (Vdemod) en combinant les signaux de sortie des premier et deuxième comparateurs.

2. Démodulateur selon la revendication 1, **caractérisé en ce que** la première cellule de détection de crête (DCR) comporte :
- une diode sur laquelle entre le signal modulé (Vdb)
- une capacité (C) en parallèle avec une source de courant (I),
le signal modulant de référence (Vpeak1) représentant la tension de charge et décharge aux bornes de la capacité (C).

3. Démodulateur selon l'une quelconque des revendications précédentes, **caractérisé en ce que** la première cellule de détection de crête (DCR) opère en outre une recopie décalée (Vpeak2) du signal modulant de référence (Vpeak1).

4. Démodulateur selon l'une quelconque des revendications précédentes, **caractérisé en ce que** la cellule de détection de crête du premier démodulateur (FE) comporte au moins un transistor (M18) passant en absence de modulation et bloqué lors de la modulation, ledit transistor (M18) étant monté en série avec une première capacité (C14) en parallèle à un premier miroir de courant (M5), le début de la modulation étant repéré par la décharge de la première capacité (C14) par le premier miroir de courant (M5).

5. Démodulateur selon l'une des revendications précédentes **caractérisé en ce que** le seuil haut de comparaison (Vdcmodshift) est généré par un décalage de la tension de décharge (Vdcmod) aux bornes d'une première capacité (C14).

6. Démodulateur selon la revendication 5, **caractérisé en ce que** la pente de la tension de décharge (Vdcmod) est comprise entre 50 et 100kV/s.

7. Démodulateur selon l'une quelconque des revendications précédentes **caractérisé en ce que** la cellule de détection de creux du second démodulateur (RE) comporte au moins un transistor (M26) bloqué en absence de modulation et passant lors de la modulation, ledit transistor (M26) étant monté en parallèle avec une deuxième capacité (C19) et en série avec un deuxième miroir de courant (M25), la fin de la modulation étant repérée par la recharge de la capacité (C19) par le miroir de courant (M25).

8. Démodulateur selon l'un des revendications précédentes **caractérisé en ce que** le seuil bas de comparaison (Vdcmodinfshift) est généré par un décalage de la tension de charge (Vdcmodinf) aux bornes d'une deuxième capacité (C19).

9. Démodulateur selon la revendication 8, **caractérisé en ce que** la pente de la tension de charge (Vdcmodinf) est comprise entre 50 et 100kV/s.

10. Démodulateur selon l'une quelconque des revendications précédentes, **caractérisé en ce que** l'unité de traitement logique comporte deux bascules (D1, D2) commandées respectivement par les comparateurs des premier et second démodulateurs (FE) (RE).

11. Démodulateur selon l'une quelconque des revendications précédentes, **caractérisé en ce qu'**il comporte en outre un système d'asservissement apte à maintenir le signal modulant de référence (Vpeak1) en dessous de la tension d'alimentation du démodulateur.

12. Dispositif sans contact, de type carte à puce, comportant un démodulateur selon l'une quelconque des revendications 1 à 11.

13. Dispositif selon la revendication 12, **caractérisé en ce qu'**il est apte à communiquer avec un organe de lecture/écriture sur une distance pouvant atteindre 1m avec une vitesse de déplacement pouvant atteindre 3m/s.

## Claims

1. A demodulator for an amplitude-modulated signal (Vdb), comprising:
- a first peak detection cell (DCR) capable of extracting the reference modulating signal (Vpeak1) from the modulated signal (Vdb), **characterized in that** it comprises :
- a first demodulator (FE) capable of producing a first shifted copy (Vmodul) of the reference modulating signal (Vpeak1) called first shifted reference signal (Vmodul), and comprising a second peak detection cell(Vdcmod) of the first shifted reference signal (Vmodul) such as to generate an upper comparison threshold (Vdcmodshift), a first comparator being provided to detect the crossing between the upper threshold (Vdcmodshift) and the first shifted reference signal (Vmodul) to define the start of the modulation. ;
- a second demodulator (RE)capable of producing a second shifted copy (Vdmodinf) of the reference modulating signal (Vpeak1) called second shifted reference signal (Vdmodinf), and comprising a trough detection cell (Vdcmodinf) of the second shifted reference signal (Vmodinf) such as to generate a lower comparison threshold (Vdcmodinfshift), the threshold being lower than the upper comparison threshold, a second comparator being provided to detect the crossing between the lower threshold (Vdcmodinfshift) and the second shifted reference signal (Vmodinf) in order to define the end of the modulation; and
- a logic processing unit capable of supplying the demodulated signal (Vdemod)by combining the output signals of the first and second comparators.

2. The demodulator according to claim 1, **characterized in that** the first peak detection cell (DCR)comprises:
- a diode to which is input the modulated signal (Vdb)
- a capacitor (C) in parallel with a current source (I),
the reference modulating signal (Vpeak1) representing the charging and discharging voltage at the terminals of the capacitor (C) .

3. The demodulator according to any one of the preceding claims, **characterized in that** the first peak detection cell (DCR) further produces a shifted copy (Vpeak2) of the reference modulating signal (Vpeak1).

4. The demodulator according to any one of the preceding claims, **characterized in that** the peak detection cell of the first demodulator (FE) comprises at least one transistor (M18) which is conducting in the absence of modulation and blocking during modulation, said transistor (M18) being series-connected with a first capacitor (C14) in parallel with a first current mirror (M5), the start of the modulation being identified by the discharge of the first capacitor (C14) by the first current mirror (M5).

5. The demodulator according to any one of the preceding claims **characterized in that** the upper comparison threshold (Vdcmodshift) is generated by a shift of the discharge voltage (Vdcmod) at the terminals of a first capacitor (C14).

6. The demodulator according to claim 5, **characterized in that** the slope of the discharge voltage (Vdcmod) ranges between 50 and 100kV/s.

7. The demodulator according to any one of the preceding claims, **characterized in that** the trough detection cell of the second demodulator (RE) comprises at least a transistor (M26) which is blocking in the absence of modulation and conducting during modulation, said transistor (M26) being connected in parallel with a second capacitor (C19) and in series with a second current mirror (M25), the end of modulation being identified by the recharge of the capacitor (C19) by the current mirror (M25).

8. The demodulator according to any one of the preceding claims, **characterized in that** the lower comparison threshold (Vdcmodinfshift) is generated by a shift of the charging voltage (Vdcmodinf) at the terminals of a second capacitor (C19) .

9. The demodulator according to claim 8, **characterized in that** the slope of the charging voltage (Vdcmodinf) ranges between 50 and 100kV/s.

10. The demodulator according to any one of the preceding claims, **characterized in that** the logic processing unit comprises two latches (D1, D2) respectively controlled by the comparators of the first and second demodulators (FE), (RE).

11. The demodulator according to any one of the preceding claims, **characterized in that** it further comprises a feedback control system capable of maintaining the reference modulating signal (Vpeak1) below the supply voltage of the demodulator.

12. A contactless device, of chip-card type, comprising a demodulator according to any one of claims 1 to 11.

13. The device according to claim 12, **characterized in that** it is capable of communicating with a read/write member over a distance that can reach 1m with a displacement speed that can reach 3m/s.

## Patentansprüche

1. Demodulator für ein amplitudenmoduliertes Signal (Vdb), umfassend:
- eine erste Signalspitzenerkennungszelle (DCR), die imstande ist, das zum Extrahieren des referenzmodulierenden Signals (Vpeak1) aus dem modulierten Signal (Vdb) imstande ist, **dadurch gekennzeichnet, dass** sie Folgendes umfasst:
- einen ersten Demodulator (FE), der zum Erzeugen einer ersten verschobenen Kopie (Vmodul) des referenzmodulierenden Signals (Vpeak1), genannt erstes verschobenes Referenzsignal (Vmodul), imstande ist und eine zweite Spitzenerkennungszelle (Vdcmod) des ersten verschobenen Referenzsignals (Vmodul) zum Erzeugen einer oberen Vergleichsschwelle (Vdcmodshift) umfasst, wobei ein Vergleicher zum Erkennen der Kreuzung zwischen der oberen Schwelle (Vdcmodshift) und dem ersten verschobenen Referenzsignal (Vmodul) zum Definieren des Beginns der Modulation vorgesehen ist;
- einen zweiten Demodulator (RE), der zum Erzeugen einer zweiten verschobenen Kopie (Vdmodinf) des referenzmodulierenden Signals (Vpeak1), genannt zweites verschobenes Referenzsignal (Vdmodinf), imstande ist und eine Tiefpunkterkennungszelle (Vdcmodinf) des zweiten verschobenen Referenzsignals (Vmodinf) zum Erzeugen einer unteren Vergleichsschwelle (Vdcmodinfshift) umfasst, wobei die Schwelle niedriger als die obere Schwelle ist, wobei ein zweiter Vergleicher zum Erkennen der Kreuzung zwischen der unteren Schwelle (Vdcmodinfshift) und dem zweiten verschobenen Referenzsignal (Vmodinf) zum Definieren des Endes der Modulation vorgesehen ist; und
- eine logische Verarbeitungseinheit, die dazu imstande ist, das demodulierte Signal (Vdemod) durch Kombinieren der Ausgangssignale des ersten und zweiten Vergleichers zuzuführen.

2. Demodulator nach Anspruch 1, **dadurch gekennzeichnet, dass** die erste Spitzenerkennungszelle (DCR)Folgendes umfasst:
- eine Diode, der das modulierte Signal (Vdb) zugeführt wird,
- einen Kondensator (C) in Parallelschaltung mit einer Stromquelle (I),
wobei das referenzmodulierende Signal (Vpeak1) die Lade- und Entladespannung an den Anschlüssen des Kondensators (C) darstellt.

3. Demodulator nach einem der vorhergehenden Ansprüche, **dadurch gekennzeichnet, dass** die erste Spitzenerkennungszelle (DCR) ferner eine verschobene Kopie (Vpeak2) des referenzmodulierenden Signals (Vpeak1) erzeugt.

4. Demodulator nach einem der vorhergehenden Ansprüche, **dadurch gekennzeichnet, dass** die Spitzenerkennungszelle des ersten Demodulators (FE) zumindest einen Transistor (M18) umfasst, der in Abwesenheit von Modulation leitet und während Modulation blockiert, wobei der Transistor (M18) mit einem ersten Kondensator (C14) parallel mit einem ersten Stromspiegel (M5) geschaltet ist, wobei der Beginn der Modulation durch die Entladung des ersten Kondensators (C14) durch den ersten Stromspiegel (M5) identifiziert ist.

5. Demodulator nach einem der vorhergehenden Ansprüche, **dadurch gekennzeichnet, dass** die obere Vergleichsschwelle (Vdcmodshift) durch eine Verschiebung der Entladungsspannung (Vdcmod) an den Anschlüssen eines ersten Kondensators (C14) erzeugt ist.

6. Demodulator nach Anspruch 5, **dadurch gekennzeichnet, dass** das Gefälle der Entladungsspannung (Vdcmod) im Bereich zwischen 50 und 100 kV/s liegt.

7. Demodulator nach einem der vorhergehenden Ansprüche, **dadurch gekennzeichnet, dass** die Tiefpunkterkennungszelle des zweiten Demodulators (RE) zumindest einen Transistor (M26) umfasst, der in Abwesenheit von Modulation blockiert und während Modulation leitet, wobei der Transistor (M26) parallel mit einem zweiten Kondensator (C19) und in Reihe mit einem zweiten Stromspiegel (M25) geschaltet ist, wobei das Ende der Modulation durch die Neuaufladung des Kondensators (C19) durch den Stromspiegel (M25) identifiziert ist.

8. Demodulator nach einem der vorhergehenden Ansprüche, **dadurch gekennzeichnet, dass** die untere Vergleichsschwelle (Vdcmodinfshift) durch eine Verschiebung der Ladungsspannung (Vdcmodinf) an den Anschlüssen eines zweiten Kondensators (C19) erzeugt ist.

9. Demodulator nach Anspruch 8, **dadurch gekennzeichnet, dass** das Gefälle der Ladungsspannung (Vdcmodinf) im Bereich zwischen 50 und 100 kV/s liegt.

10. Demodulator nach einem der vorhergehenden Ansprüche, **dadurch gekennzeichnet, dass** die logische Verarbeitungseinheit zwei Latches (D1, D2) umfasst, die jeweils durch die Vergleicher des ersten und zweiten Demodulators (FE), (RE) gesteuert sind.

11. Demodulator nach einem der vorhergehenden Ansprüche, **dadurch gekennzeichnet, dass** er ferner ein Feedback-Steuersystem umfasst, das imstande ist, das referenzmodulierende Signal (Vpeak1) unter der Speisespannung des Demodulators zu halten.

12. Kontaktlose, chipkartenartige Vorrichtung, umfassend einen Demodulator nach einem der Ansprüche 1 bis 11.

13. Vorrichtung nach Anspruch 12, **dadurch gekennzeichnet, dass** sie dazu imstande ist, mit einem Lese-/Schreibglied über eine Entfernung, die 1 m erreichen kann, mit einer Verschiebungsgeschwindigkeit, die 3 m/s erreichen kann, zu kommunizieren.
